# EUROPEAN PATENT SPECIFICATION

(11) **EP 1 174 530 B1**
(45) Date of publication and mention of the grant of the patent: **30.04.2008**
(21) Application number: 01306212.0
(22) Date of filing: 19.07.2001
(51) Int. Cl.: C25D 5/54

(54) **Method of producing conductor layers on dielectric surfaces**
Verfahren zur Herstellung von leitenden Schichten auf dielektrischen Oberflächen
Procédé de fabrication de couches conductrices sur des surfaces diélectriques

(30) Priority: 20.07.2000 LT 2000074
(43) Date of publication of application: 23.01.2002
(73) Proprietor: Shipley Company LLC, Marlborough, MA 01752 (US)
(72) Inventor: Baranauskas, Myokolas, 2022 Vilnius (LT)
(74) Representative: Kent, Venetia Katherine

(56) References cited:
- WO-A-00/29646
- GB-A- 1 534 638
- US-A- 3 620 834
- US-A- 4 919 768
- US-A- 5 484 518

## Description

### BACKGROUND OF THE INVENTION

### 1. Field of the Invention.

The present invention pertains to modification of qualities of a dielectric surface, in particular to render a dielectric surface to be an electric conductor. The invention may be used e.g. in various areas of industry for the preparation of dielectric surfaces of electroplating, especially for nickel-plating. Dielectric items which are metal-coated by processes of the invention may be used e.g. where a decorative or protective function is required, in manufacturing press-forms using the galvanoplastic method, or for assemblies for shielding electromagnetic emission.

### 2. Background.

One existing certain method of producing conductor surfaces is known (USSR patent No 980858, B 05 D 5/12 1982), in which the dielectric surface is treated by amine-salt solution of copper, then immersed in water, then in sulphide solution and then rinsed with water.

Using this method, a quality conductor surface can be obtained by repeating the operation sequence described in the USSR patent at least three times. This increases the duration of the entire process, increases the consumption of water and chemicals and makes the use of automated production lines more difficult.

In addition, another certain existing process for producing conductor surfaces of cupric sulphide is known (USSR patent No 1762454, H 05 K 3/42, 3/18, 1991), in which dielectric items are immersed into solution of univalent cupric salt, then into a solution of 0.0025 / 0.025 of potassium persulphate, iodine or potassium nitrite solution, then rinsed with water and immersed into sulphide solution of an alkaline metal. This process is carried out at room temperature and each operation is repeated twice.

The shortcomings of the method described in USSR patent No 1762454 are the same as the shortcomings described in the preceding patent. In addition, through application of both existing methods, it is impossible to leave an isolated part of the item uncovered, i.e., it is impossible to achieve selective conductor coating.

See also the patent application of the Republic of Lithuania No 98-161, published in the official bulletin of Lithuanian State Patent Bureau (VPB) No 5 in 2000. That reported method also has notable shortcomiongs, including problematic use of a cobalt solution.

US-A-5 484 518 discloses a process for electroplating by coating a substrate with a liquid dispersion of conductive particles. WO-A-00 29646 discloses a process for metallization of a plastic surface using a treatment of Co, Ag, Sn or Pb solution, and a sulfide solution treatment.

It would be desirable to have new methods to render a dielectric surface electrically conductive.

The present invention, in its various aspects, is as set out in the accompanying claims.

### SUMMARY OF THE INVENTION

The present invention enables selective production of quality conductor metal sulphide coatings on a dielectric surface without the use of ammonia hydroxide or amine, and to make the process shorter.

The invention also enables producing conductor coatings with the use of stable ionic solutions.

More particularly, methods of the invention include treating a dielectric surface with a composition comprising bismuth and with sulfur (sulfide) treatment. The dielectric substrate is treated with a solution that contains bismuth ions, particularly trivalent bismuth ions. The treated substrate is then treated with a sulfide solution. A water rinse can be suitably employed between the treatment with bismuth composition and the sulfur treatment.

Prior to the treatment with a bismuth composition, a dielectric substrate is suitably etched. A variety of etchants may be employed. Generally preferred is an acidic aqueous solution that comprises e.g. KIO₄, or K₂S₂O₈ and CrO₃.

A variety of sulfur compositions also may be employed. An aqueous solution containing a sulfur salt is generally preferred, e.g. a sodium or potassium sulphide water solution.

Methods of the invention enable selective production of quality metal sulphide conductor coating on dielectric surface without using ammonia hydroxide, amines or other compounds that form strong complex compounds with heavy metals. In addition, methods of the invention produce conductor coatings uses metal ion solution which are highly stable. That is, in distinction from prior systems, bismuth treatment compositions of the invention are highly stable for extended periods. See, for instance, the results set forth in Table 1 below.

The invention also includes articles having a metal plate thereon produced in accordance with the disclosed methods.

Methods and articles of the invention are useful for a wide variety of applications, including for forming electrical circuits and conductors such as present on a printed circuit board or other electronic packaging substrate, a metal finish, and other applications such as producing electromagnetic shielding. The methods of the invention are particularly useful to deposit a decorative or protective nickel plate, or other decorative or protective metal layer.

Other aspects of the invention arc disclosed infra.

### DETAILED DESCRIPTION OF THE INVENTION

The invention provides new methods for plating dielectric substrates, particularly polymer substrates such as e.g. ABS (acrylonitrile butadiene styrene) copolymer substrates, epoxy resin substrates, polyetherimide substrates.

The methods of the invention generally include use of a bismuth treatment step. Subsequent treatment with a sulfide material or composition enables quality metallization of the substrate, e.g. with an electrolytic nickel, copper, gold, silver, platinum or other metal plating composition solution. In contrast to other prior systems, plating catalysts such as Pd, or Pd./tin, platinum or other metal need not be employed to deposit the metal layer. Also, unstable treatment solutions such cobalt need not be employed.

To enhance the metal deposits on the dielectric substrate, preferably the dielectric substrate is first treated with an etchant solution that can provide a chemically and physically modified surface that is optimized for subsequent conditioning and plating. Such materials typically contain a strong oxidant and include the acidic compositions discussed above as well as alkali permanganate compositions.

Treatment compositions employed in accordance with the invention may be applied to a dielectric substrate by a variety of methods, including by spray application as well as immersion. A treatment composition is typically applied as a solution to a substrate.

A variety of bismuth compositions may be employed in accordance with the invention. A trivalent bismuth species is particularly preferred. Both inorganic and organic bismuth materials are suitably employed such as Bi(NO₃)₃, BiCl₂ or Bi(CH₃COO)₃. Those bismuth compositions are preferably present in an acidic aqueous solution, such as a HCI, HNO₃ or acetic acid solution. The solution may contain relatively small amount of the bismuth material, e.g. the solution may suitably be from 0.0001 1 to 1 molar in bismuth ions, preferably a bismuth ion concentration of 0,005 to 0.5 molar, even more preferably a bismuth ion concentration of 0.005 to 0.3 molar in an aqueous treatment solution.

The bismuth composition may be applied to a dielectric substrate at room temperature to achieve good results, although the bismuth solution also may be at an elevated temperature.

After treatment with the bismuth composition, the substrate is then treated with a sulfide composition, preferably an aqueous solution that contains a sulfide species, e.g. a sulfur salt such as Na₂S or K₂S, or an organic sulfide, such as an alkyl sulfide. N₂S or K₂S is generally preferred.

The sulfide composition also may be applied to a dielectric substrate at room temperature to achieve good results, although a sulfide composition solution also may be at an elevated temperature.

Times of treatment of a dielectric substrate with the above compositions can vary rather widely. In general, treatment times of from 0.25 to 10 minutes arc suitable, more typically from 0.5 to 1, 2, 3, 4 or 5 or more minutes.

Preferably, a treated dielectric substrate is rinsed with water between treatment steps, i.e. after etching, after bismuth treatment and then after sulfur treatment. The substrate may be suitably dried before plating.

A variety of metals may be plated onto a dielectric substrate. Plating compositions are commercially available. For instance, suitable electrolytic copper, nickel and gold plating compositions are available from the Shipley Company (Marlborough, Massachusetts). A preferred nickel electroplating plating composition and method for use thereof is set forth in the examples below. See also, Coombs, Printed Circuits Handbook, (3rd Edition, McGraw Hill), incorporated herein by reference, for additional suitable plating compositions and uses thereof.

Preferred electrolytic copper plating compositions for use in accordance with the invention include an aqueous composition that contains an aqueous solution of CuSO₄ 5H₂O at a concentration of 60 g/l; H₂SO₄ at a concentration of 225 g/l; and Cl ions at a concentration of 50 ppm. The treated substrate to be plated is suitably immersed in an air-agitated plating tank outfitted with multiple cathode rails and one rectifier and charged with such a copper plating solution. During plating, the following deposition conditions are suitably employed; current density of 14.5 mA/cm²; DC waveform was DC; and plating bath temperature of 25°C.

References herein to solutions of materials are inclusive of fluid materials where all solid components are dissolved therein, as well as fluid compositions where one or more added components are dispersed or otherwise not fully dissolved in the fluid. Preferably, most or all added components are fully dissolved in the fluid carrier (typically water).

The following non-limiting examples are illustrative of the invention.

### GENERAL COMMENTS TO EXAMPLES

In the following examples, products made of dielectric-plates made of ABS (a copolymer of vinyl cyanide, divinyl and styrene) plastic substance are etched for 5 minutes at room temperature in solution which contains 13M H₃PO₄ and 0.5M K₂S₂O₈ or etched for 5 minutes in 60 °C temperature solution which contains 3.8M H₂SO₄ and 3.8M CrO₃ and rinsed with water.

In the following examples, products of dielectric-shock-resistant polystyrene (SAPS) are etched for 5 minutes in solution containing 17M H₂SO₄ and 0.5M KIO₄ under room temperature and rinsed with water.

After etching, the products are treated for 2 minutes in solution which contains 0.005 /0.300 M Bi(NO₃)₃ or BiCl₃ or Bi(CH₃COO)₃ and 0.01 /0.35 M HNO₃ or HCl or CH₃COOH, under room temperature. After this, products arc rinsed with water and for further 30 seconds treated in solution containing 0,01 / 0,25 M Na₂S or K₂S at room temperature.

When the process is completed, the items are rinsed with distilled water, dried and nickel plated for 15 minutes in Watts electrolyte which contains 1 / 1.2M NiSO₄; 0.15/0.2 M NiCl₂ and 0.4/0.5 M H₃BO₃, initial flow density 0.3 A/dm², which, along the progress of nickel coating from the point of contact, increases to 3 A/dm², under electrolyte temperature of 40° C.

Stability of the metal ion solution is assessed, examining the presence of sediment in solution (which means that the solution is unstable) or their absence (which means that the solution is stable).

The smoothness of the conductive sulphide coating is assessed visually immediately after the treatment, in daylight, using two parameters: smooth, not smooth.

Electrical conductivity of the coating is assessed by the chemical nickel-plating expansion speed from the point of contact, in centimetres per minute.

The possibility of selectively producing conductor coating on a dielectric item is assessed by examining whether isolated part of the item is covered in nickel or not.

In the following Examples 1 through 7, Examples 1, 3 and 6 arc for control purposes, while Examples 2, 4, 5 and 7 have been prepared in accordance with the proposed method, under different concentrations of bismuth component ions, and using different technological means.

In Examples 3, 4, 5, 6 and 7, subjected to treatment are ABS plastic plates with surface area of 50 cm², while in Example 2 there are profiled items made of shock-resistant polystyrene (SAPS) with surface area of 70 cm².

### EXAMPLE 1

Profiled articles from shock-resistant polystyrene, with surface area of 70 cm², etching 5 minutes at room temperature with 17M H₂SO₄ and 0.5M KIO₄.

Items are rinsed with water after etching and treated for 10 minutes in solution which contains 0.01M CoF₃ and 0.35M NH₄OH, under room temperature. After this, the items are rinsed in acetic acid up to pH 5 in acid water and treated for 30 seconds in sulphide solution which contains 0.1 M Na₂S.

After treatment, the items arc rinsed with distilled water, dried and nickel-plated for 15 minutes in Watts electrolyte, containing (M): NiSO₄ - 1.2; NiCl₂ - 0.2 and H₃BO₃ - 0.5; initial flow density 0.3 A/dm², temperature 40 °C.

### EXAMPLE 2

Profiled items made from shock-resistant polystyrene are etched in accordance with the method described in Example 2.

After etching, items are rinsed with water and treated for 2 minutes in a solution containing 0.01M Bi(No₃)₃ and 0.03M HNO₃ under room temperature. Afterwards, the items arc rinsed in water and treated for 30 seconds in a sulphide solution which contains 0.1M Na₂S.
After treatment, the items arc rinsed with distilled water, dried and nickel-plated for 15 minutes in Watts' electrolyte, as described in Example 1.

### EXAMPLE 3

Plates of ABS plastic with surface area of 50 cm² are etched for 5 minutes at room temperature solution containing 13M H₃PO₄ and 0.5M K₂S₂O₈.
After etching, the plates are rinsed with water and treated for 10 minutes in a solution containing 0,25M CoCl₂ and 0.7M triethanolamine under room temperature. Following this, the plates are rinsed with water, the alkalinity of which is brought to pH 9.0 by Na₂CO₃, and treated for 30 seconds in a sulphide solution which contains 0.01M sodium sulphide under room temperature.

After treatment, the items are rinsed with distilled water, dried and for 15 minutes nickel-plated in Watts' electrolyte, as described in Example 1.

### EXAMPLE 4

ABS plastic plates are etched for 5 minutes at room temperature in a solution, containing 13M H₃PO₄ and 0.5M K₂S₂O₈.

After etching, plates are rinsed with water and treated for 2 minutes in a solution containing 0.3M bismuth acetate and 0.35M acetic acid, at room temperature. After this, plates are rinsed in water and treated for 30 seconds in a sulphide solution which contains 0.01M Na₂S, at room temperature.

After treatment, the items are rinsed with distilled water, dried and nickel-plated for 15 minutes in Watts' electrolyte, as described in Example 1.

### EXAMPLE 5

ABS plastic plates are etched for 5 minutes in a solution at room temperature, containing 13M H₃PO₄ and 0.5M K₂S₂O₈.

After etching, plates are rinsed with water and treated for 2 minutes in a solution containing 0.005 Bi(NO₃)₃ and 0.01M HNO₃ at room temperature. After this, plates are rinsed in water and treated for 30 seconds in a sulphide solution which contains 0.01M Na₂S at room temperature.

After treatment, the items are rinsed with distilled water, dried and nickel-plated for 15 minutes in Watts' electrolyte, as described in Example 1.

### EXAMPLE 6

ABS plastic plates are etched for 5 minutes in 60 °C solution, containing 3.8M H₂SO₄ and 3.8M CrO₃.

After etching, plates arc rinsed with water and treated for 10 minutes in a solution, containing 0.01M CoF₃ and 0.04M monoethanolamine, at room temperature. After this, plates are rinsed in water, brought to alkalinity of pH 14 by NaOH and treated for 30 seconds in a sulphide solution which contains 0.25M K₂S at room temperature.

After treatment, the items, are rinsed with distilled water, dried and nickel-plated for 15 minutes in Watts' electrolyte, as described in Example 1.

### EXAMPLE 7

ABS plastic plates are etched for 5 minutes in 60 °C solution, containing 3.8M H₂SO₄ and 3.8M CrO₃.

After etching, plates are rinsed with water and treated for 2 minutes in a solution containing 0.01M BiCl₃ and 0.03M HCl, at room temperature. After this, plates are rinsed in water and treated for 30 seconds in a sulphide solution which contains 0,25M K₂S at room temperature.

After treatment, the items are rinsed with distilled water, dried and nickel-plated for 15 minutes in Watts' electrolyte, as described in Example 1.

Data about coating qualities are given in Table 1 below. Data shown in Table 1 below indicate that under different dielectric items and different regimes of their etching, the new method of producing coatings is not longer and the quality of the coating is not inferior to that obtained by known methods, while in some cases the quality of the new method coating is indeed superior.

**TABLE 1**

| EXAMPLES | | | | | | | |
|---|---|---|---|---|---|---|---|
| Composition of solutions, technological and quality indices of coatings | 1 (control) | 2 | 3 (control) | 4 | 5 | 6 (control) | 7 |
| Dielectric | | | | | | | |
| Etching solution | H₂SO₄ + H₂O + KIO₄ | H₂SO₄ + H₂O + KIO₄ | H₂SO₄ + H₂O + K₂S₂O₈ | H₂SO₄ + H₂O + K₂S₂O₈ | H₂SO₄ + H₂O + K₂S₂O₈ | H₂SO₄ + H₂O + CrO₃ | H₂SO₄ + H₂O + CrO₃ |
| Metallic ion solution composition (m) and stability: | CoF₃ - 0.01 NH₄OH - 0. 12. | Bi(NO₃)₃ - 0.01 HNO₃ - 0.03 | CoCl₂ - 0.3 triethanolamine - 07 | Bi(CH₃COO)₃- 0.3 CH₃COOH - 0.35 | Bi(NO₃)₃ - 0.005 HNO₃ - 0.01 | CoF₃ - 0:01 monoethanolamine - 0.04 | BiCl₃ - 0.01 HCl - 0.03 |
| stable (+) or unstable (-) | - | + | - | + | + | - | + |
| Quantity of consecutive treatments in solution | 1 | 1 | 1 | 1 | 1 | 1 | 1 |
| Nickel plating of plastic surface, complete (+) or Incomplete (-) | + | + | + | + | + | + | + |
| Speed of electroplating spread from point of contact, cm/min | 3-4 | 5-7 | 2-3 | 6-8 | 3-4 | 3-4 | 6-8 |
| Smoothness of coating | Smooth | smooth | smooth | smooth | smooth | smooth | smooth |
| Dielectric metal-coated selectively (+) or non-selectively (-) | + | + | + | + | + | + | + |

## Claims

1. A process for metal deposition, comprising treating a substrate with a solution that contains bismuth ions and then a sulfide solution and then metal plating the substrate.

2. The process of claim 1 wherein the substrate is treated with trivalent bismuth.

3. The process of claim 1 or 2 wherein the substrate is first treated with the bismuth solution and then treated with aqueous sulfide solution.

4. The process of any one of claims 1-3, wherein the sulfide is an inorganic or organic sulfide.

5. The process of any one of claims 1 through 4, wherein the sulfide is Na₂S or K₂S.

6. The process of any one of claims 1-5, wherein the bismuth solution is an aqueous solution having a bismuth ion concentration of from 0.0005 to 0.3M.

7. The process of any one of claims 1-6, wherein the sulfide solution is an aqueous sulfide solution.

8. The process of any one of claims 1 through 7 wherein the substrate is electrolytically plated with nickel.

9. The process of any one of claims 1 through 7 wherein the substrate is electrolytically plated with copper.

10. The process of any one of claims 1 through 8, wherein the substrate is electrolytically plated with gold.

11. The process of any one of claims 1 through 10, wherein the substrate is treated with an etchant prior to treatment with the bismuth solution.

12. The process of any one of claims 1 through 11, wherein the substrate surface comprises a dielectric material.

13. The process of any one of claims 1 through 12, wherein the substrate surface comprises an epoxy resin, acrylonitrile butadiene styrene, or a polyetherimide.

14. The process of any one of claims 1 through 13, wherein the substrate is an electronic packaging substrate.

15. The process of any one of claims 1 through 14, wherein the metal plate provides a decorative or protective function.

16. The process of any one of claims 1 through 15, wherein the substrate is treated with water after treatment with the bismuth solution and before treatment with the sulfide solution.

17. An article of manufacturing, comprising a substrate plated with a metal according to the process claimed in any one of claims 1 through 16 having an electrolytic metal deposit thereon, and a bismuth material and sulfur respectively underlying the metal deposit.

18. The article of claim 17, wherein the substrate is an electromagnetic shielding material.

## Patentansprüche

1. Verfahren zur Metallabscheidung, umfassend das Behandeln eines Substrates mit einer Lösung, die Bismutionen enthält, und dann mit einer Sulfidlösung, und dann das Metallplattieren des Substrates.

2. Verfahren nach Anspruch 1, wobei das Substrat mit dreiwertigem Bismut behandelt wird.

3. Verfahren nach Anspruch 1 oder 2, wobei das Substrat zuerst mit der Bismutlösung behandelt wird und dann mit wäßriger Sulfidlösung behandelt wird.

4. Verfahren nach einem der Ansprüche 1 bis 3, wobei das Sulfid ein anorganisches oder organisches Sulfid ist.

5. Verfahren nach einem der Ansprüche 1 bis 4, wobei das Sulfid Na₂S oder K₂S ist.

6. Verfahren nach einem der Ansprüche 1 bis 5, wobei die Bismutlösung eine wäßrige Lösung mit einer Bismutionenkonzentration von 0,0005 bis 0,3 M ist.

7. Verfahren nach einem der Ansprüche 1 bis 6, wobei die Sulfidlösung eine wäßrige Sulfidlösung ist.

8. Verfahren nach einem der Ansprüche 1 bis 7, wobei das Substrat elektrolytisch mit Nickel plattiert wird.

9. Verfahren nach einem der Ansprüche 1 bis 7, wobei das Substrat elektrolytisch mit Kupfer plattiert wird.

10. Verfahren nach einem der Ansprüche 1 bis 8, wobei das Substrat elektrolytisch mit Gold plattiert wird.

11. Verfahren nach einem der Ansprüche 1 bis 10, wobei das Substrat mit einem Ätzmittel vor der Behandlung mit der Bismutlösung behandelt wird.

12. Verfahren nach einem der Ansprüche 1 bis 11, wobei die Substratoberfläche ein dielektrisches Material umfaßt.

13. Verfahren nach einem der Ansprüche 1 bis 12, wobei die Substratoberfläche ein Epoxyharz, Acrylnitril-Butadien-Styrol oder ein Polyetherimid umfaßt.

14. Verfahren nach einem der Ansprüche 1 bis 13, wobei das Substrat ein elektronisches Verpackungssubstrat ist.

15. Verfahren nach einem der Ansprüche 1 bis 14, wobei die Metallplattierung eine dekorative oder schützende Funktion bereitstellt.

16. Verfahren nach einem der Ansprüche 1 bis 15, wobei das Substrat mit Wasser nach der Behandlung mit der Bismutlösung und vor der Behandlung mit der Sulfidlösung behandelt wird.

17. Herstellungsgegenstand, umfassend ein Substrat, plattiert mit einem Metall gemäß dem Verfahren nach einem der Ansprüche 1 bis 16, mit einer elektrolytischen Metallabscheidung darauf, und einem Bismutmaterial bzw. Schwefel, welches unter der Metallabscheidung angeordnet ist.

18. Gegenstand nach Anspruch 17, wobei das Substrat ein elektromagnetisches Abschirmungsmaterial ist.

## Revendications

1. Procédé pour le dépôt de métal comprenant le traitement d'un substrat avec une solution qui contient des ions bismuth et ensuite avec une solution de sulfure et le placage subséquent du substrat avec du métal.

2. Procédé selon la revendication 1, dans lequel le substrat est traité avec du bismuth trivalent.

3. Procédé selon la revendication 1 ou 2, dans lequel le substrat est traité dans un premier temps avec la solution de bismuth et est ensuite traité avec une solution aqueuse de sulfure.

4. Procédé selon l'une quelconque des revendications 1-3, dans lequel le sulfure est un sulfure inorganique ou organique.

5. Procédé selon l'une quelconque des revendications 1 à 4, dans lequel le sulfure est Na₂S ou K₂S.

6. Procédé selon l'une quelconque des revendications 1-5, dans lequel la solution de bismuth est une solution aqueuse ayant une concentration en ions bismuth de 0,0005 à 0,3M.

7. Procédé selon l'une quelconque des revendications 1-6, dans lequel la solution de sulfure est une solution aqueuse de sulfure.

8. Procédé selon l'une quelconque des revendications 1 à 7, dans lequel le substrat est plaqué électrolytiquement avec du nickel.

9. Procédé selon l'une quelconque des revendications 1 à 7, dans lequel le substrat est plaqué électrolytiquement avec du cuivre.

10. Procédé selon l'une quelconque des revendications 1 à 8, dans lequel le substrat est plaqué électrolytiquement avec de l'or.

11. Procédé selon l'une quelconque des revendications 1 à 10, dans lequel le substrat est traité avec un agent décapant avant le traitement avec la solution de bismuth.

12. Procédé selon l'une quelconque des revendications 1 à 11, dans lequel la surface du substrat comprend un matériau diélectrique.

13. Procédé selon l'une quelconque des revendications 1 à 12, dans lequel la surface du substrat comprend une résine époxy, un acrylonitrile butadiène styrène ou un polyétherimide.

14. Procédé selon l'une quelconque des revendications 1 à 13, dans lequel le substrat est un substrat d'emballage électronique.

15. Procédé selon l'une quelconque des revendications 1 à 14, dans lequel la plaque de métal fournit une fonction décorative ou protectrice.

16. Procédé selon l'une quelconque des revendications 1 à 15, dans lequel le substrat est traité avec de l'eau après le traitement avec la solution de bismuth et avant le traitement avec la solution de sulfure.

17. Article de manufacture comprenant un substrat plaqué d'un métal selon le procédé selon l'une quelconque des revendications 1 à 16 présentant un dépôt électrolytique de métal sur son dessus et un matériau de bismuth et du soufre se trouvant respectivement sous le dépôt de métal.

18. Article selon la revendication 17, dans lequel le substrat est un matériau d'écran électromagnétique.
